Europäisches Patentamt

(19) European Patent Office

Office européen des brevets

(11) Numéro de publication: **0 064 000**
**B1**

(12) **FASCICULE DE BREVET EUROPEEN**

(45) Date de publication du fascicule du brevet:
**11.06.86**

(51) Int. Cl.⁴: **H 01 P 7/10**

(21) Numéro de dépôt: **82400691.0**

(22) Date de dépôt: **16.04.82**

(54) Résonateur diélectrique réglable, notamment pour oscillateur hyperfréquence, et procédé de réglage d'un tel résonateur.

(30) Priorité: **21.04.81 FR 8107919**

(43) Date de publication de la demande:
**03.11.82 Bulletin 82/44**

(45) Mention de la délivrance du brevet:
**11.06.86 Bulletin 86/24**

(84) Etats contractants désignés:
**DE GB IT NL SE**

(56) Documents cités:
**FR - A - 1 075 057**
**FR - A - 1 415 052**
**FR - A - 2 376 554**
**US - A - 2 428 037**
**US - A - 2 528 387**
**US - A - 2 549 499**
**US - A - 2 874 327**
**US - A - 3 560 885**
**US - A - 4 019 161**
**US - A - 4 020 428**

(73) Titulaire: **SOCIETE D'ELECTRONIQUE DE LA REGION PAYS de LOÎRE - SEREL, 74, rue du Surmelin, F-75020 Paris (FR)**

(72) Inventeur: **Luong, Thierry, THOMSON-CSF SCPI 173, bld Haussmann, F-75379 Paris Cedex 08 (FR)**

(74) Mandataire: **Grynwald, Albert et al, THOMSON-CSF SCPI 19, avenue de Messine, F-75008 Paris (FR)**

LIBER, STOCKHOLM 1986

## Description

La présente invention concerne les résonateurs diélectriques réglables, notamment pour un oscillateur hyperfréquence qui comprend en outre des élements actifs ou passifs dont le résonateur stabilise la fréquence d'oscillation. Les éléments actifs d'un tel oscillateur sont,de préférence, à semiconducteur, tels que des diodes à résistance négative connues, par exemple du type à avalanche, à temps de transit, à effet GUNN ou READ, ou des transistors à effet de champ (à arséniure de gallium par exemple) ou bipolaires. Ses éléments passifs sont, de préférence, de circuits à constantes réparties du type "microbande". L'invention concerne, plus particulièrement, un procédé et un moyen pour le réglage définitif de la fréquence d'un tel oscillateur, contenu de manière inaccessible dans un boîtier métallique fermé, pouvant êtrerendu étanche.

Par l'expression "hyperfréquence", on comprendra dans ce qui suit des fréquences supérieures à 1 GHz.

Des résonateurs diélectriques réalisés en un matériau céramique à constante diélectrique (ou permittivité) relative élevée (par rapportà celle de l'air ou du vide) sont bien connus par exemple, de la publication GB-A-752 467, où l'on a préconisé l'utilisation de titanates, notammentde baryum ($BaTiO_3$) ou de strontium ($SrTiO_3$) ou de leurs mélanges, connus, dans la construction de condensateurs céramiques, pour leurs permittivités élevées, ainsi que pour leurs effets piézo- et ferroélectriques (amplificateurs, modulateurs diélectriques et convertisseurs mécanoélectriques). Plus récemment, on préfére utiliser des matériaux céramiques du genre oxyde métallique, notamment de titane ($TiO_2$), de zinc ($ZnO$), de baryum ($BaO$), de magnésium ($MgO$ appelé magnésie), d'étain ($SnO_2$), de zirconium ($ZrO_2$ appelé zircone) ou des mélanges de cesoxydes, par exemple, de permittivité relative moins élevée ($\varepsilon$r entre 30 et 40), qui assurent des pertes plus faibles et une meilleure stabilité en température de la fréquence de résonance du résonateur. Les dimensions réduites de ces résonateurs diélectriques par rapport à celles des cavités métalliques creuses, facilitent leur utilisation en tant qu'éléments résonnants passifs dans des circuits hyperfréquence hybrides ou integres ("microwave integrated circuits" ou "MIC" en anglais) utilisant la technique"microbande" ("microstrip" en anglais) pour réaliser des réactances à constantes réparties. L'utilisation d'un résonateur diélectrique pour la stabilisation d'un oscillateur hyperfréquence a été décrit, notamment, dans les publications FR-A- 2 376 554, 2 436 527 et 2 438 937, en ce qui concerne des circuits du type "microbande", et, notamment, dans la publication US-A-4 008 446, en cas d'utilisation de guides d'ondes et de cavités métalliques.

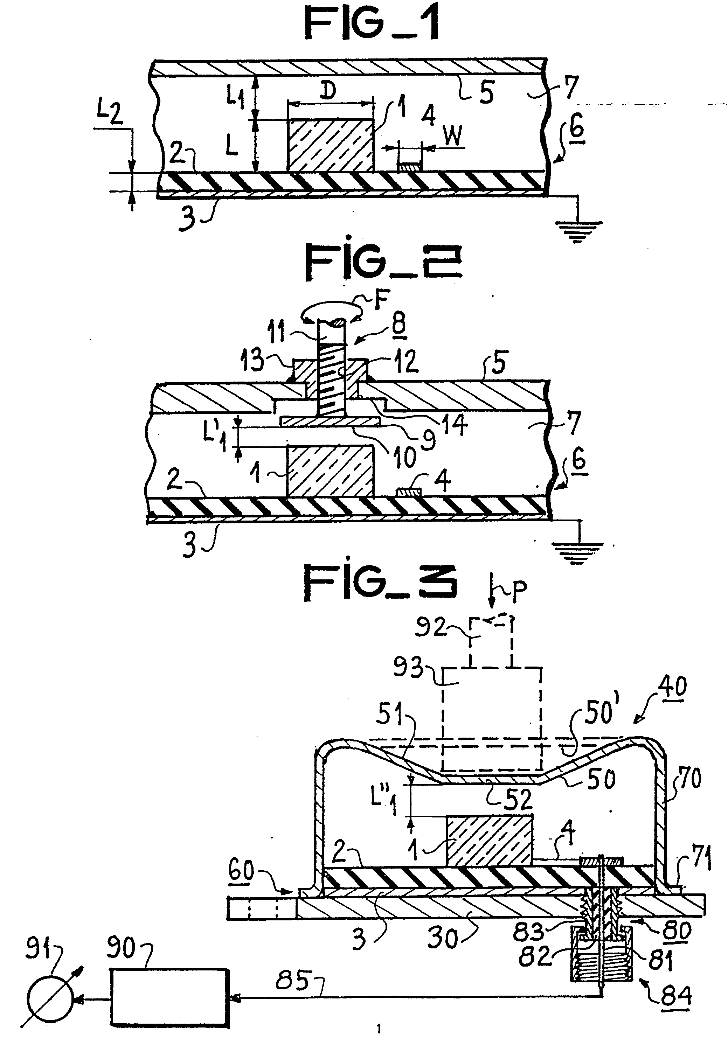

En ce qui concerne les procédés pour faire varier la fréquence de résonance d'un résonateur diélectrique, l'un d'eux se trouve décrit aux pages 184 et 185 de la publication américaine "1974 IEEE International Solid-State Circuits Conference, Digest of Technical Papers", Vol. XVII, dans un résumé de la conférence de G.SATOH intitulée "STABILIZED MICROSTRIP OSCILLATOR USING A TEMPERATURE-STABLE DIELECTRIC RESONATOR" qui a eu lieu le 15 février 1974. On y décrit des oscillateurs hyperfréquence à diode GUNN, et on montre sur la figure 2, schematiquement une méthode pour régler la fréquence de résonance d'un résonateur diélectrique de forme cylindrique, au moyen d'une vis métallique située au-dessus de sa face supérieure, de façon à faire varier la distance entre cette face et la surface métallique du fond de la vis. On y voit également que la fréquence varie en fonction inverse de cette distance. La gamme de variation utile de cette fréquence de résonance est de 120 MHz environ pour une puissance d'au moins 40mW. Un tel procédé est également décrit dans le document US-A-4019161.

Un procédé analogue a été décrit aux pages 168 et 169 de la publication américaine "1977 IEEE International Solid-State Circuits Conférence Digest of Technical Papers," Vol. XX, dans le résumé de la conférence de H. ABE, Y. TAKAYAMA, A.HIGASHISAKA et H.TAKAMIZAWA intitulée "A STABILIZED, LOW-NOISE GaAs FET INTEGRATED OSCILLATOR WITH A DIELECTRIC RESONATOR AT C-BAND" qui s'est tenue le 17 février 1977, ou dans un article des mêmes auteurs aux pages 156 à 161 de la revue américaine "IEEE TRANSACTIONS ON MICROWAVE THEORY AND TECHNIQUES", Vol. MTT- 26, N° 3, de mars 1978. Dans ces publications, l'oscillateur hyperfréquence comprend un transistor à effet de champ en arséniure de gallium, monté en source commune, et un résonnateur diélectrique (composé principalement de $BaTi_4O_9$) dont la fréquence de résonance peut être ajustée à l'aide d'une vis coulissante portant une plaque métallique déplaçable de façon à faire varier la distance entre sa face inférieure et la face supérieure du résonateur, illustré sur la figure 1 (a). La gammede variation de la fréquence d'oscillation atteint ici au moins 800 MHz. Du fait que l'accord est effectué par le déplacement d'une vis ou d'une plaque métallique, la résistance du mécanisme d'accord aux vibrations et aux chocs, ainsi que sa stabilité en température pour des écarts importants(de -30°C à +40°C, par exemple), laissent à désirer. De plus l'étanchéité du mécanisme de réglage ne peut être assurée qu'à un prix de revient relativement élevé.

Un autre procédé pour accorder, c'est-à-dire faire varier la fréquence de résonance, d'un résonateur diélectrique, a été proposé aux pages 197 à 199 de la publication américaine "1979 IEEE MTT-S International Microwave Symposium Digest", dans un résumé de la conférence de T.SAITO, Y.ARAI, H.KOMIZO, Y.ITOH et T.NISHIKAWA, intitulée"A6-GHz HIGHLY STABILIZED GaAs FET OSCILLATOR USING A DIELECTRIC RESONATOR". Ce nouveau procédé permet une gamme de variation 50 MHz environ et assure une meilleure stabilité en temperature que les mécanismes à vis ou à plaque métallique décrits ci-dessus. L'oscillateur qui y a été décrit comporte un amplificateur équipé d'un transistor à effet de champ en arséniure de gallium et muni d'une boucle de réaction sélective comprenant un résonateur diélectrique en forme d'anneau (en un mélange de $SnO_2$, de $TiO_2$ et de ZrO), logé verticalement et centré dans une cavité métallique au moyen d'une entretoise en céramique ($2MgO$ $SiO_2$), ce qui contribue à améliorer sa stabilité en température. Ce résonateur annulaire est muni d'un trou excentré qui le traverse de part en part et dans lequel peut être insérée une tige cylindrique du même matériau diélectrique que le résonateur. La profondeur de l'insertion de la tige dans le trou fait varier la fréquence de l'oscillateur (pour des profondeurs d'insertion ailant de 0 à 3 mm, la fréquence varie sensiblement entre 6,1 et 5,9 MHz). La résistance mécanique peu élevée du mécanisme du déplacement axial de la tige aux vibrations, et celle de la tige en céramique elle-même aux chocs, exige des manipulations du dispositif avec précaution, et son étanchéité, dufait de la présence d'une pièce mobile, est difficilement réalisable et implique, de ce fait, un coût élevé.

Le calcul de la fréquence de résonance dans le mode TE 01 $\delta$ d'un résonateur diélectrique cylindrique dans un circuit de type "microbande", où il est posé sur l'une des faces d'un substrat isolant en céramique (alumine) ayant une permittivité relative $\varepsilon p$ différente de celle $\varepsilon$ r du matériau constitutif du résonateur dont la face supérieure est disposée à une distance prédéterminée d'une plaque conductrice formant couvercle, a été effectué par M.W. POSPIESZALSKI et publié dans le compte-rendu aux pages 168 à 175 de la publication en langue anglaise "7TH EUROPEAN MICROWAVE CONFERENCE, CONFERENCE PROCEEDINGS" de Septembre 1977, ou aux pages 233 à 238 de la revue américaine "IEEE TRANSACTIONS ON MICROWAVE THEORY AND TECHNIQUES", Volume MTT-27, N°3, de mars 1979. On y retrouve également le réglage de l'accord par vis (figure 5, page 236). Un des paramètres permettant de déterminer la fréquence de résonance du résonateur est le rapport entre la distance qui sépare sa face supérieure du couvercle et sa propre hauteur, d'où il découle que le choix de la hauteur du boîtier métallique formant écran, pui contient l'ensemble du circuit en "microbande" et qui en est recouvert, permet de déterminer la fréquence d'oscillation de l'oscillateur, qui n'est alors pas ajustable. Une telle conception du circuit, sans autre disposition pour le réglage de la fréquence, exige des tolérances de fabrication qui nécessitent un usinage individuel de précision, trop coûteux pour la fabrication en grande série, mais permet une utilisation en faible quantité, car en choisissant le matériau du boîtier en un alliage dont le coefficient de dilatation thermique est comparable à ceiui du matériau céramique du résonateur, on obtient une très bonne stabilité en température, une résistance aux chocs et vibrations mécanique et une étanchéité (herméticité) excellente.

La présente invention permet d'éviter les inconvénients des solutions de l'état de la technique susmentionné, tout en permettant d'assurer simultanément l'étanchéité et l'ajustabilité de la fréquence par un moyen mécanique avec une stabilité en température satisfaisante et un prix de revient adapté à une utilisation par le grand public.

Suivant l'invention, un résonateur diélectrique réglable, du type comprenant un résonateur diélectrique contenu dans un boîtier conducteur fermé comportant un plafond sensiblement plan et parallèle à la face supérieure du résonateur, est principalement caractérisé en ce que le plafond du boîtier peut être déformé de manière permanente, à la fabrication, pour en rapprocher de la face supérieure du résonateur la partie adjacente de celui-ci sans déformer les autres parties du boîtier, ce qui augmente la fréquence de résonance du résonateur jusqu'à la valeur de réglage désirée.

Un autre objet de l'invention est le procédé de réglage de la fréquence de fonctionnement de ce résonateur. Ce procédé de réglage ou d'ajustement définitif de la fréquence de résonance d'un résonateur diélectrique est applicable à tout éiément sélectif utilisant de tels résonateurs (filtres par exemple).

L'invention sera mieux comprise, et d'autres caractéristiques et avantages ressortiront de la description qui suit et des dessins ciannexés, s'y rapportant, sur lesquels:.
- la figure 1 est une coupe axiale partielle en élévation d'un boîtier contenant un résonateur diélectrique dans un circuit du type "microbande" ou un circuit intégré hyperfréquence (MIC), sans moyens mécaniques de réglage de sa fréquence de résonance;,
- la figure 2 est une coupe axiale en éiévation analogue à la figure 1, où le résonateur diélectrique est associé à un moyen mécanique de reglage de sa fréquence de résonance, selon l'état de la technique susmentionné; et
- la figure 3 est une coupe axiale partielle en élévation d'un mode de réalisation des moyens de réglage définitif de la fréquence de résonance du résonateur diélectrique, suivant l'invention.

Sur la figure 1, on a représenté en 1 le résonateur diélectrique sous la forme la plus courante pui consiste en un petit cylindre plein en un matériau (céramipue) à permittivité relative ($\varepsilon_r$) élevée età faibles pertes diélectriques (tg $\delta$). D'autres formes, telles que cubique, parallélepipédique ou tubulaire (annulaires), peuvent être utilisées, qui ont été mentionnées notamment dans l'article de S.B. COHN aux pages 218 à 227 de la revue américaine "IEEE TRANSACTIONS ON MICROWAVE THEORY AND TECHNIQUES", Vol. MTT-16, N°4, d'Avril 1968 (voir page 220, figure 1), où l'on a illustré également la configuration des champs electrique et magnétique (lignes de force) dans le mode fondamental (TE 01 δ). Le fait que les lignes de force magnétiques débordent de la surface du corps du résonateur facilite son couplage magnétique reciproque avec un conducteur disposé à proximité, dans un plan normal à l'axe de sa paroi cylindripue, ou avec une boucle à l'axe parallèle ou coaxiale avec cet axe (voir également dans les publications FR-A-2 376 554 et 2 438 937 precitées).

On remarquera ici que la frépuence de résonance d'un résonateur diélectrique cylindrique dépend notamment, de ses dimensions (par exemple, pour un diamètre de 5 mm et une hauteur de 3 mm, on obtient une fréquence de résonance propre de l'ordre de 11 GHz).

Le résonateur diélectrique 1 est placé ici dans son environnement courant qui est constitué par un circuit hyperfréquence à"microbandes" ou un circuit intégré microondes (MIC) qui comporte un substrat 2 plan en un matériau isolant diélectrique (de préférence à faibles pertes), d'épaisseur $L_2$ et de constante diélectrique $\varepsilon_p$ prédéterminées, tel qu'une des plaques de silice ($SiO_2$) ou d'alumine ($Al_2O_3$), par exemple. Lesubstrat 2 est entièrement recouvert sur l'une des ses faces (inférieure) d'une couche métallipue conductrice 3 formant plan de masse. Le circuit hyperfréquence (à constantes réparties) prend la forme de bandes ou rubans 4 en matériau métallipue conducteur recouvrant en partie l'autre face (supérieure) du substrat 2, dont l'épaisseur $L_2$ ainsi que la permittivité relative $\varepsilon$, contribue, conjointement avec la largeur w des bandes conductrices 4, à déterminer l'impédance caractéristique $Z_0$ des tronçons de ligne de transmission asymétriques ainsi formés.

Sur la face (supérieure) du substrat 2 portant les bandes conductrices 4, pui y ont été déposées par photolithographie ou tout autre procédé connu de la fabrication des circuits imprimés ou intégrés (vernis photosensible), on fixe la base inférieure plane du résonateur diélectrique 1 cylindripue de longueur (hauteur) L et de diamètre D calculés, par exemple, à l'aide des formules de POSPIESZALSKI publiées dans les publications susmentionnées, en tenant également compte de permittivités relatives $\varepsilon_r$ et $\varepsilon_p$ respectives du résonateur 1 et du substrat 2, de l'épaisseur $L_2$ de ce dernier et de la distance $L_1$ qui sépare la face supérieure plane du résonateur 1 de la plaque métallique 5 conductrice qui constitue le couvercle du boîtier 6 contenant l'oscillateur hyperfréquence, pour obtenir la fréquence de résonance $F_0$ désirée. Comme les valeurs calculées ne correspondent pu'approximativement à cette valeur désirée, le seul terme variable pui subsiste après la réalisation et le montage des composantes est cette distance $L_1$ qu'il faudra alors ajuster en réduisant la hauteur des parois latérales 7 du boîtier 6 jusqu'à l'obtention de la fréquence $F_0$ de

l'onde fournie par l'oscillateur (non represente). Pour permettre un usinage de précision (fraisage), le boîtier6 doit avoir des parois latérales épaisses afin qu'il soit suffisamment rigide. L'étanchéité du boîtier 6 peut être assurée à l'aide d'un jointen caoutchouc s'insérant dans une gorge pratiquée dans la tranche supérieure des parois latérales 7 ou par la soudure ou brasure d'un couvercle 5 sur cette tranche. Le prix de revient d'un tel oscillateur hyperfréquence à fréquence non réglable, mais ajustée avec précision, est élevé etson industrialisation difficile. Dans le compte rendu de la conférence de S. SHINOZAKI, T.HAYASAKA et K. SAKAMOTO, publié aux pages 294 à 296 de la publication américaine "1978 IEEE MTT-S International Microwave Symposium Digest", ainsi que dans la publication FR-A-2 438 937, on a proposé un réglage électrique de la fréquence de résonance du résonateur 1 à l'aide d'une diode à capacité variable permettant de faire varier la fréquence de résonance d'un tronçon de ligne à microbande, couplé au résonateur 1.

La figure 2 représente, en coupe axiale en élévation, un résonateur diélectripue 1 dans son environnement de la figure 1 et muni d'un dispositif mécanique de réglage de sa frépuence de résonance selon l'état de la technique antérieure, connu notamment des comptes rendus des conférences de SATOH, de ABE et al. et de l'article de POSPIESZALSKI.

Le couvercle ou plafond 5 du boîtier 6 doit, dans ce cas, présenter une épaisseur suffisante pour pouvoir supporter le mécanisme 8 commandant les déplacements du dispositif d'accord constitué ici par une plaque métallique 9 discoforme dont la face inférieure plane 10 est parallèle à la base supérieure plane du résonateur cylindrique 1. Le disque 9 est axialement aligné avec le résonateur 1 et présente un diamètre, de préférence, au moins égal à celui de ce dernier. Il peut être réalisé en un matériau analogue à celui utilisé pour le boîtier 6, tel que du cuivre ou qu'un alliage de cuivre (avec du zinc - laiton, ou avec d'autres métaux - bronze) éventuellement recouverts sur les faces internes d'une mince couche d'argent ou d'or, par exemple. Le mécanisme 8 comporte une vis métallique 11 qui est vissée dans le trou taraudé 12 d'un écrou 13 métallique, soudé ou brasé à la paroi supérieure (plafond) 5 du boîtier 6. Ce trou peut être perce et taraude dans cette paroi meme. L'extrémité inférieure de la vis 11 pénètre à l'intérieur du boîtier 6 où elle est réunie, par brasage ou soudure par exemple, à la face supérieure de la plaque 9. La paroi supérieure 5 du boîtier 6 peut être munie d'une cavité cylindrique 14 permettant d'y escamoter le disque 9 (voir les publications d'ABE et a1.),afin d'étendre la gamme de variation des fréquences vers le bas. La rotation de la vis 11 dans les sens de la double flèche F permet d'ajuster la distance $L'_1$ qui sépare la face inférieure 10 du disque métallique 9 de la face supérieure du résonateur cylindrique 1.

L'oscillateur hyperfréquence agencé conformément à la presente invention est destiné, notamment, à équiper la tête hautefréquence d'un recepteur d'ondes electromagnétiques modulées, retransmises ou émises par un émetteur de liaison hertzienne, notamment par un satellite émettant dans la bande des 12 GHz, en tant qu'oscillateur local à fréquence fixe. Cette tête haute-fréquence qui comprend, en outre, un premier mélangeur ou convertisseur hétérodyne hyperfréquence que cet oscillateur alimente, ainsi qu'un amplificateur de ces ondes reçues, transposées par ce premier mélangeur ou convertisseur, est contenue dans un boîtier monté sur le réflecteur parabolique d'une antenne de réception située à l'extérieur.

Ce boîtier, et la tête haute fréquence qu'il contient, doivent pouvoir supporter, de ce fait, des intempéries, des variations extrêmes de la température, de l'humidité ambiante et des vibrations causées par les vents, tout en conservant un fonctionnement fiable et, notamment, une fréquence d'oscillateur local relativement stable puisqu'aucune commande automatique de la fréquence n'y est prévue (voir, par exemple, l'article de HAWKER aux pages 27 à 35 de la revue britannique"IBA Technical Review" de juillet 1978 ou l'article de FREEMAN aux pages 234 à 236 de la revue britannique "The Radio and Electronic Enginéer", Vol. 47, N°5, de mai 1977). De ce qui précède, on peut voir aisément qu'un tel premier oscillateur local n'est pas accessible à l'utilisateur et malaisément même pour le personnel d'entretien. Il est a noter, en outre, que dans les formules de POSPIESZALSKI, les permittivités relatives du substrat ($\varepsilon_p$) et du résonateur ($\varepsilon_r$) sont définies par rapport à celle de l'air contenu dans le boîtier (6) qui varie avec son degré hygrométrique, c'est-à-dire son contenu de vapeurs d'eau. Il est donc indispensable qu'un oscillateur local faisant partie d'une unité extérieure (dite "OUTDOOR UNIT" en anglais) soit réglé à sa fréquence désirée une fois pour toutes et hermétiquement clos dans son boîtier particulier.

Ceci est obtenu à l'aide de la disposition suivant l'invention, illustrée sur la figure 3 et décrite ci-après.

La figure 3 illustre en coupe axiale partielle en élévation d'un mode de réalisation suivant l'invention des moyens de réglage définitif de la fréquence de résonance d'un résonateur diélectrique, simples et peu coûteux, vus sous un angle différent de celui des figures 1 et 2.

L'ensemble de l'oscillateur hyperfréquence stabilisé par le résonateur diélectrique 1 est contenu dans un boîtier 60 compact et étanche, semblable à ceux (du type TO-3, CB-19, CB-159) utilisés pour des transistors bipolaires de puissance. Ce boîtier 60 comporte une embase métallique 30 plate et épaisse et un couvercle en forme de coupelle ou pot 40 composé d'une paroi latérale cylindrique 70 et d'un fond plat formant plafond 50, realisé en tôle métallique (emboutie). L'extrémite libre de sa paroi latérale ou jupe 70 est repliée pour former une lèvre 71 qui constitue une surface annulaire parallèle au fond 50 avant sa déformation (etat non-déformé indiqué par des tirets 50'). Cette lèvre annulaire 71 est destinée à être soudée sur toute sa circonférence à la face supérieure de l'embase 30 après l'assemblage sur celle-ci du circuit "microbande" ou intégré hyperfréquence (MIC) comprenant le substrat 2 avec son plan de masse 3 contigu à l'embase 30 (à laquelle il est éventuellement électriquement relié par un point de soudure), les microbandes 4 et les éléments actifs (transistor, diode à résistance négative) et passifs (condensateurs de découplage, selfs de choc, résistances ou charges adaptées) permettant la poiarisation des précédents, ainsi que le résonateur diélectrique 1. Pour réaliser cet oscillateur on peut utiliser toute configuration de l'état dela technique utilisant la technologie des circuits"microbande" ou "MIC". L'oscillateur doit comporter une traversée (passage) coaxiale étanche 80 permettant de fournir à l'extérieur l'onde hyperfrépuence pu'il engendre.

Le problème à résoudre est d'accorder cet oscillateur hyperfréquence compact à la frépuence de fonctionnement désirée, postérieurement à son montage dans son boîtier 60 et à la fermeture étanche (hermétipue) de celui-ci. Pour que cela soit possible, la hauteur de la jupe 70 du couvercle doit être telle que la distance initiale entre le plafond 50' non-déformé donne une frépuence d'oscillation inférieure à celle quel'on doit obtenir par ie réglage suivant l'invention.

Le passage coaxial étanche 80 pui traverse l'embase 30 comporte un conducteur centrai (ou âme) 81 qui est reliè ou couplé au circuit "microbande" et traverse le substrat 2 de part en part, à travers le milieu d'une zone circulaire d'interruption du plan de masse 3 recouvrant la face inférieure du substrat 2. Une pièce isolante tubulaire 82 entoure ce conducteur central 81, et il est lui-même entouré d'un conducteur extérieur en forme de cylindre métallique rigide 83 dont l'extrémité supérieure est vissée de manière serrée dans un trou taraudé pratique dans l'embase 30. L'extrémité inférieure du conducteur extérieur 83 porte une fiche coaxiale mâle 84 miniature. Pour obtenir une bonne étanchéité, la pièce isolante 81 peut être insérée à force dans le cylindre 83 pui l'entoure ou bien, si elle est réalisée avec une résine durcissable (poly mérisante), introduite dans celui-ci sous forme lipuide, par exemple. Il est également possible de souder le conducteur extérieur 83 sur l'embase 30.

Pour effectuer le réglage définitif de la fréquence de l'oscillateur, on relie sa sortie hyperfréquence 80 (c'est-à-dire le conducteur central 81) à l'aide d'un câble coaxial 85 à un dispositif de mesure de fréquence 90 tel pu'un compteur électronique (muni d'un convertisseur hétérodyne, voir catalogue des appareils de mesure HEWLETT-PACKARD, édition 1977, pages 243 à 245), ou un ondemètre à cavité suivi d'un détecteur àdiode ou d'un appareil de mesure de la puissance à thermistor, bolomètre ou thermocouple, dont la partie affichage est symbolisée par le repère 91.

Lorsque l'appareil de mesure de fréquence est mis sous tension, on applique les tensions de polarisation à l'élément actif de l'oscillateur contenu dans le boîtier 60 (par l'intermédiaire de broches non représentées) que l'on a préalablement placé dans une presse à commande manuelle, mécanique ou électrique, dont on a représenté la tige 92 etla mâchoire supérieure 93 par des tirets. La mâchoire inférieure de la presse n'a pas été représentée, car elle ne sert qu'à maintenir en position l'embase 30 qu'elle supporte.

L'application d'une pression dans la direction de la flèche P par la mâchoire supérieure mobile 93, alignée axialement avec le résonateur diélectrique 1, a pour effet de déformer le couvercle 40 du boîtier 60 de manière à y former une cuvette 51 dont le fond 52 est sensiblement parallèle à la face supérieure du résonateur 1, lorsque le diamètrede la mâchoire supérieure 93, également cylindrique, est supérieur à celui du résonateur 1.

Lorsque l'appareil 90, 91 indique que la fréquence désirée a été atteinte, on ôte la mâchoire 93 du couvercle 40 et l'on vérifie si la fréquence désirée se maintient. Ceci se produit soit lorsque ie matériau métallique constitutif du couvercle est peu élastipue, ou lorsque la déformation est suffisamment grande pour que sa limite d'élasticité ait été dépassée (cette considération intervient dans le choix de la hauteur de la paroi latérale 70 du couvercle 40).

Lorsqu'à la suite du retrait de la mâchoire 93, il y a une variation (diminution) de la fréquence fournie par l'oscillateur, on mesure l'écart entre celle-ci et la fréquence désirée. Ensuite, on remet la mâchoire93 en place et on réapplique la pression jusqu'à ce qu'une fréquence égale à la somme de la fréquence désirée et de l'écart mesuré soit affichée ou mesurée. Après un nouveau retrait de la mâchoire 93, on obtient alors avec une très grande probabilité la fréquence désirée avec une tolérance satisfaisante (que l'on peut lire sur l'appareil de mesure). Il faut toutefois prendre soin de ne pas dépasser de trop la fréquence désirée lors de l'application ou de la réapplication de la pression, car il n'est pas possible de revenir à une fréquence inférieure sans démonter le couvercle 40 qui a déjà été soudé.

L'invention n'est pas limitée au mode de réalisation décrit et représenté sur la figure 3, mais s'étend également à d'autres formesde résonateurs diélectriques, de boîtiers et de couvercles. Notamment, il est possible d'utiliser des résonateurs à base carrée ou rectangulaire, par exemple. En ce qui concerne le matériau constitutif du résonateur 1, on peut notamment avantageusement utiliser du titanate de zirconium. Le boîtier 6 ou 60 contenant l'oscillateur peut être cylindrique creux avec la base et les parois latérales métalliques rigides (du fait de leur épaisseur) et comporter un couvercle plat en forme de disque, soudé sur le pourtour de la tranche de la paroi latérale, formé d'un matériau d'épaisseur (de tôle) suffisamment réduite pour être déformable de manière permanente.

Il est également possible d'utiliser un boîtier parallélépipédipue à parois latérales rigides avec un couvercle en tôle rectangulaire ou carré, fixé par des vis et avec un joint d'étanchéité, ou soudé à la paroi latérale. La traversée coaxiale étanche peut être montée de manière à traverser non pas le fond (embase) du boîtier, mais l'une de ses parois latérales. Il est également avantageux de repérer, sur la surface extérieure du couvercle, la verticale de la circonférence du résonateur diélectrique, afin d'appliquer la pression le déformant à l'endroit le plus adapte. D'autres formes de la mâchoire mobile de la presse peuvent être utilisées, car il n'est pas nécessaire que la cuvette présente un fond plat, ni que sa forme soit adaptée à celle du resonateur.

L'utilisation pour le boîtier d'un alliage métallique conducteur ayant un coefficient de dilatation thermique faible proche de ceux des céramiques est également avantageux pour la stabilité en température.

Par ailleurs, le couplage de l'oscillateur avec son circuit de charge, tel qu'un mélangeur hétérodyne ou amplificateur parametrique, par exemple, ne s'effectue pas nécessairement au moyen d'une fiche coaxiale miniature 84 terminant le passage étanche 80, mais, par exemple également au moyen d'une sonde coaxiale ("probe" en anglais) ayant une âme métallique (81) et un fourreau cylindrique en matériau isolant (polytétrafluoroéthylène, par exemple) à l'endroit de l'extrémitédu conducteur central qui s'insère dans un guide d'onde.

Il est à noter ici que le boîtier 60, avant d'être complétement ferme, peut être pompe par une pompe à vide ou rempli de gaz ou d'air sec (étuvage).

Le procédé de réglage définitif de la fréquence de résonance d'un résonateur diélectrique, par la déformation du boîtier qui est l'un des objets de l'invention, s'applique non seulement à des oscillateurs hyperfréquence à circuits en "microbande" et stabilisés au moyen de ce résonateur, mais également aux réglages d'éléments sélectifs passifs, tels que des filtres passe-bande ou de réjection de bande utilisant de tels résonateurs, ainsi qu'à des amplificateurs hyperfréquence sélectifs ayant de tels résonateurs couplés à leurs circuits d'entrée et/ou de sortieet/ou de contre-réaction. Toutefois, comme les filtres passifs ou actifs (amplificateurs sélectifs) ne sont pas supposés engendrer des oscillations, il est alors nécessaire de relier leur entrée à un générateur de signaux (d'ondes) hyperfréquence (voir catalogue HEWLETT-PACKARD précité, pages 345 à 347) ou à un oscillateur modulé en fréquence ("wobbulateur" ou en anglais "SWEEP OSCILLATOR" - voir même catalogue pages 355-369), les premiers étant associés à des détecteurs ou des appareils de mesure de puissance à thermocouple ou thermistance (bolometre) susmentionnés et les seconds à des oscilloscopes pour visualiser la caractéristique amplitude-fréquence.

Lorsque le circuit sélectif à accorder comporte plusieurs résonateurs diélectriques, ceux-ci sont, de préférence, situés dans des compartiments séparés par des cloisons métalliques et le capot ou couvercle recouvrant chacun de ces résonnateurs ou compartiments doit être déformable de manière indépendante pour que les réglages soient précis.

Le produit (oscillateur ou filtre passif ou actif) ainsi obtenu sera compact, solide et inderéglable par des moyens courants avec un prix de revient réduit qui se prête à la fabrication en grande série. Le procédé de réglage, objet de l'invention, se prête à l'automatisation de l'accord final (définitif) à la fabrication.

On peut également noter ici que, en ce qui concerne le boîtier 60 du type utilisé dans l'oscillateur de la figure 3, on peut ut réalisation du capot 40 de la feuille (tôle) un alliage d'aluminium (avec du cuivre et/ou du silicium et/ou du manganèse et/ou du magnésium), tel que celui appelé "DURAL" ou "DURALUMIN", par exemple, d'épaisseur comprise entre 0,3 et 0,5 mm, de préférence. On peut également utiliser une tôle en acier inoxydable, de préférence, austénitique d'épaisseurs comparables (de quelques dizièmes de millimètres), en recouvrant avantageusement les faces internes du capot 40 d'une couche de métal meilleur conducteur que le fer (argent, or, platine ou cuivre). En ce qui concerne l'embase 30 d'épaisseur plus importante (de quelques millimètres), il est avantageux d'utiliser un alliage de cuivre, tel que le bronze ou le laiton, ou de l'aluminium, par exemple.

## Revendications

1. Résonateur diélectrique réglable, du type comprenant un résonateur diélectrique (1) contenu dans un boîtier conducteur fermé (60) comportant un plafond (50) sensiblement plan et parallèle à la face supérieure du résonateur, caractérisé en ce que le plafond (50) du boîtier peut être déformé de manière permanente, à la fabrication, pour en rapprocher de la face supérieure du résonateur (1) la partie adjacente de celui-ci sans déformer les autres parties du boîtier, ce qui augmente la fréquence de résonance du résonateur jusqu'à la valeur de réglage désirée.

2. Résonateur selon la revendication 1, caractérisé en ce que le boîtier comprend une embase (30) sur laquelle repose le résonateur diélectrique (1), et un capot (60) formé d'une jupe latérale (70) fixée sur l'embase et surmontée ·dudit plafond (50); l'épaisseur du plafond permettant qu'il soit déformé de manière permanente lorsque la fréquence de réglage est obtenue, par dépassement de la limite élastique du matériau qui le compose.

3. Résonateur selon la revendication 3, caractérisé en ce qu'il comprend en outre un circuit microbande formé d'un substrat (2) reposant par une face munie d'un plan de masse (3) sur l'embase et supportant sur l'autre face le résonateur diélectrique (1) et un ensemble de tronçons de ligne (4) formant un circuit dans lequel est inséré le résonateur diélectrique; ce circuit étant réuni à des moyens de couplage (80, 84) avec l'extérieur.

4. Résonateur selon la revendication 3, caractérisé en ce que le circuit formé par les tronçons de ligne (4) est un oscillateur hyperfréquence dont le résonateur diélectrique (1) stabilise la fréquence de l'oscillation.

5. Procédé de réglage d'un résonateur diélectrique réglable du type comprenant un resonateur diélectrique contenu dans un boîtier conducteur fermé comportant des moyens de couplage, caractérisé en ce qu'il comprend les étapes suivantes:.
- on réunit les moyens de couplage (80, 84) à des moyens d'alimentation (90), et à des moyens de mesure (91) d'un paramètre caractéristique du réglage du résonateur;,
- on exerce une pression progressive sur le plafond (50) du résonateur ce qui le déforme en faisant varier ledit paramètre caractéristique;
- on cesse d'exercer la pression lorsque la valeur du paramètre correspondant au réglage désiré est atteinte.

6. Procédé selon la revendication 5, caractérisé en ce qu'il comprend en outre les étapes supplémentaires suivantes:
- après le retrait de la pression sur le plafond (50), on mesure l'écart entre la valeur du paramètre atteinte sous pression et la valeur résiduelle lorsque la pression est retirée;,
- on exerce de nouveau une pression progressive sur le plafond jusqu'à atteindre une valeur du paramètre égale à la valeur atteinte lors de la première pression augmentée dudit écart;
- on supprime définitivement cette pression.

## Patentansprüche

1. Einstellbarer dielektrischer Resonator, vom Typ mit einem elektrischen Resonator (1), der in einem leitfähigen, geschlossenen Gehäuse (60) enthalten ist, welches eine im wesentlichen ebene und zur Oberseite des Resonators parallele Deckfläche (50) umfaßt, dadurch gekennzeichnet, daß die Deckfläche (50) des Gehäuses bei der Herstellung dauerhaft deformiert werden kann, um ihren dem Resonator (1) benachbarten Teil an dessen Oberseite anzunähern, ohne die anderen Teile des Gehäuses zu deformieren, wodurch die Resonanzfrequenz des Resonators bis auf den gewünschten Einstellwert erhöht wird.

2. Resonator nach Anspruch 1, dadurch gekennzeichnet, daß das Gehäuse einen Sockel (30) umfaßt, auf welchem der dielektrische Resonator (1) ruht, und eine Haube (60) umfaßt, die durch eine seitliche Stütze (70) gebildet ist, welche an dem Sockel befestigt ist und von der Deckfläche (50) überragt wird; wobei die Dicke des Deckflächenteils bei Erreichen der Einstellfrequenz die dauerhafte Deformierung dieses Deckflächenteils durch Überschreiten der Elastizitätsgrenze des Materials gestattet, aus welchem es besteht.

3. Resonator nach Anspruch 3, dadurch gekennzeichnet daß er ferner einen Mikro-Streifenleitungskreis umfaßt, der gebildet ist aus einem Substrat (2), welches mit einer, mit einer Masseebene (3) versehenen Fläche auf dem Sockel ruht und auf der anderen Fläche den dielektrischen Resonator (1) trägt, und aus einer Gruppe von Leitungsabschnitten (4), die einen Kreis bilden, in welchen der dielektrische Resonator eingefügt ist; wobei dieser Kreis an Mittel (80, 84) zum Ankoppeln an die Umgebung versehen ist.

4. Resonator nach Anspruch 3, dadurch gekennzeichnet, daß der durch die Leitungsabschnitte (4) gebildete Kreis ein Mikrowellenoszillator ist, worin der dielektrische Resonator (1) die Schwingungsfrequenz stabilisiert.

5. Verfahren zum Abstimmen eines einstellbaren dielektrischen Resonators vom Typ mit einem dielektrischen Resonator, der in einem geschlossenen leitfähigen Gehäuse enthalten ist, welches Kopplungsmittel umfaßt, dadurch gekennzeichnet, daß es folgende Schritte umfaßt:
- die Kopplungsmittel (80, 84) werden an Speisemittel (90) und an Mittel (91) zur Messung eines Kennparameters für die Einstellung des Resonators angeschlossen;
- auf die Deckfläche (50) des Resonators wird ein progressiver Druck ausgeübt, wodurch diese deformiert wird, indem der Kennparameter verändert wird;
- die Druckausübung wird eingestellt, wenn der Parameterwert erreicht ist, welcher der gewünschten Einstellung entspricht.

6. Verfahren nach Anspruch 5, dadurch gekennzeichnet, daß es ferner folgende weitere Schritte umfaßt:
- nach Wegnahme des Druckes auf die Deckfläche (50) wird die Abweichung zwischen dem unter Druck erreichten Parameterwert und dem verbleibenden Wert nach Wegnahme des Druckes gemessen;
- es wird erneut ein progressiver Druck auf die Deckfläche ausgeübt, bis ein Parameterwert erreicht ist, der gleich dem um die genannte Abweichung vergrößerten Wert ist, welcher während der ersten Druckausübung erreicht wurde;
- die Druckausübung wird endgültig unterbunden.

**Claims**

1. Adjustable dielectric resonator of the type comprising a dielectric resonator (1) contained in a conductive closed housing (60) comprising a substantially plane ceiling (50) which is parallel to the upper face of the resonator, characterized in that the ceiling (50) of the housing is susceptible to be deformed in permanent manner during manufacture in order to approach its portion adjacent to the resonator (1) to the upper face thereof without deforming the other portions or the housing, whereby the resonance frequency of the resonator is increased until the desired adjustment value is reached.

2. Resonator according to claim 1, characterized in that the housing comprises a base (30) whereon the dielectric resonator (1) rests, and a hood (60) formed of a lateral skirt (70) secured to the base and overtopped by said ceiling (50); the thickness of the ceiling permitting its permanent deformation when the adjustment frequency is reached by exceeding the resiliency limit of the material whereof it is composed.

3. Resonator according to claim 3, characterized in that it further comprises a microstrip circuit formed of a substrate (2) resting on the base through one face provided with a ground plane (3), and the other face of which carries the dielectric resonator (1), and a set of line sections (4) forming a circuit wherein the dielectric resonator is inserted; this circuit being connected to means (80, 84) for coupling to the outside.

4. Resonator according to claim 3, characterized in that the circuit formed by the line sections (4) is a microwave oscillator wherein the dielectric resonator (1) stabilizes the oscillating frequency.

5. Method of adjusting an adjustable dielectric resonator of the type comprising a dielectric resonator contained in a closed conductive housing, comprising coupling means, characterized in that it comprises the following steps:
- the coupling means (80, 84) are connected to supply means (90) and to means (91) for the measurement of a parameter which is characteristic of the adjustment of the resonator;
- a progressive pressure is imposed onto the ceiling (50) of the resonator whereby it is deformed and said characteristic parameter is varied;
- the pressure is removed when the value of the parameter corresponding to the desired adjustment is reached.

6. Method according to claim 5, characterized in that it further comprises the following additional steps:
- after removal of the pressure on the ceiling (50) the deviation between the value of the parameter reached under pressure and the residual value when the pressure is removed is measured;
- a progressive pressure is again imposed upon the ceiling until a value of the parameter is reached which is equal to the value obtained during the action of the first pressure increased by said deviation;

- this pressure is definitively removed.

# FIG_1

# FIG_2

# FIG_3